Europäisches Patentamt

European Patent Office

Office européen des brevets

(11) Publication number : **0 482 891 A2**

# (12) EUROPEAN PATENT APPLICATION

(21) Application number : **91309760.6**

(22) Date of filing : **22.10.91**

(51) Int. Cl.⁵ : **H01J 37/34**

(30) Priority : **22.10.90 US 601848**

(43) Date of publication of application :
**29.04.92 Bulletin 92/18**

(84) Designated Contracting States :
**DE FR GB IT NL**

(71) Applicant : **VARIAN ASSOCIATES, INC.**
**3100 Hansen Way**
**Palo Alto, California 94304-1030 (US)**

(72) Inventor : **Demaray, Richard E.**
**5006 Crystal Ridge Court**
**Oakland, California 94608 (US)**
Inventor : **Hoffman, Vance E.**
**295 Loucks**
**Los Altos, California 94022 (US)**

(74) Representative : **Cline, Roger Ledlie et al**
**EDWARD EVANS & CO. Chancery House 53-64**
**Chancery Lane**
**London WC2A 1SD (GB)**

(54) **High vacuum magnetron sputter source.**

(57) A vacuum sputter apparatus capable of performing sputter operations at reduced operating pressure. Magnetic means is supported behind the cathode for producing magnetic flux lines generally parallel to a first, primary surface to be sputtered which is held at a high electrical potential, thus giving rise to a magnetron plasma adjacent the primary surface. The magnetic means confines the plasma to produce a closed loop erosion path on the first surface. A dark space shield extends from the wall of the vacuum chamber toward the first surface, but terminates a distance from the primary surface so as to expose a portion of the second surface. The dark space shield is recessed a sufficient distance from the first target surface to minimize the density of the fringing field lines intersecting the dark space shield. In this manner, the plasma generated adjacent the first surface is enriched both by electrons originating from a secondary plasma at the second surface and by electrons reflected back to the first surface moving along the magnetic flux lines. Sputtering action can thus take place efficiently at reduced operating pressure. Reduced operating pressure furthermore provides more uniform film deposition, while eliminating differential segregation of the sputter compound material.

FIG. I

EP 0 482 891 A2

The present invention relates to a vacuum sputter coating apparatus capable of performing sputter operation at reduced operating pressure.

## BACKGROUND OF THE INVENTION

Sputtering is used for film deposition on a substrate in a vacuum environment. A target made of the material to be deposited on a substrate is connected to a negative voltage supply and positioned in facing and spaced relationship with the substrate. A sputter gas, typically argon, is introduced to initiate and maintain a magnetron plasma. The pressure required to sustain sputtering action is in the range of 0.4-1.3 Pa. A magnet means positioned behind the target generates a circle of arches so that a substantially parallel magnetic field is obtained near the surface of the sputter target at right angles to the electric field in a first erosion region on the face of the target. This is the region in which sputtering occurs.

It has been generally desirable to minimize magnetic field lines extending to the side surface of the target so as to minimize impacts by charged particles upon the side surface, and consequent sputtering therefrom. Such sputtering from side surfaces is generally undesirable, since the trajectories of the resulting sputtered particles are not directed to the substrate, and moreover are usually not comprised of the desired coating material. Thus the material sputtered from sidewalls has been thought undesirable as merely contributing to the potential particulate or contaminant problem, which can cause impurities which are imparted to the deposition composition. Arcing along the cathode side surface and charged particle impacts can be suppressed by a grounded dark space shield extending slightly over the outside edge of the target so that no magnetron charge occurs on the periphery of the target. Dark space shields are flush with the cathode surface or extend beyond (or in front of) the target surface. As the electrons are generated due to the action of the electric and magnetic fields, some follow fringing magnetic field lines to the dark shield. They thus reach ground and are lost. One example illustrating the function of such shields is U.S. Patent No. 4,166,018 to Chapin.

The operating gas pressure at which sputtering occurs significantly affects the efficiency and uniformity of the sputter process. As the pressure is increased, the mean free path of molecule collisions decreases accordingly, resulting in scattering. This molecular collision causes the sputter material to reach the substrate to be coated at relatively low angles such that the film deposition will not have the desired chemical composition or uniformity. Thus, it is desirable to lower the operating pressure of the sputter environment. However, this has been difficult to do, since the efficacy of the sputtering action depends on the concentration of ionizable gas atoms, and thus generally cannot be lowered beyond certain limits without seriously impacting the functioning of the basic sputtering process.

One attempt at lowering pressure of the sputter process is described by Cuomo et al. in U.S. Patent No. 4,588,490. Cuomo et al. discloses the use of a hollow cathode discharge into the plasma region of a magnetron sputter source so as to achieve low pressure magnetron operation. The argon sputter pressure can be reduced by utilizing a separate power supply for the hollow cathode discharge and a red to white hot hollow cathode injector tube near the magnetron cathode and the substrate to be coated. However, the very hot cathode tube and geometric asymmetry cause nonuniform magnetron discharge and greater erosion on the side of the hollow cathode discharge, resulting in a nonuniform film deposited on the substrate. Additionally, the power supplied to the hollow cathode is equivalent to the power supplied to the planar magnetron during operation. These two power supplies provide about twice the power required to sputter at standard conditions. This creates a very hot deposition condition so that, as discussed above, films of nonuniform thermal properties and, hence, poor quality are obtained.

U.S. Patent No. 4,825,544 to Mikalesen et al. describes a hollow cathode discharge utilized to support low pressure operation for sputtering through a particle collimation filter to produce "lift off" like films having enhanced bottom thickness in submicron semiconductor contact and via holes. The nonuniform sputter erosion produced by the hollow cathode enhanced magnetron require that the substrate be translated and/or rotated during deposition to produce a uniform film. Thus, additional mechanical means must be provided in vacuum. Additionally, this causes the average rate of deposition to be reduced from the average rate of deposition characterizing the steady state sputter rate through the collimator.

By reducing scattering it is possible to overcome some of the attendant undesired effects and, thereby, minimize alteration of the composition of the deposition layer on the substrate. European Patent Aplication No. 91300567.4 discloses a collimating filter disposed between the target and substrate to be coated so as to limit the angles at which the particles can impinge the substrate. Unlike Mikalesen discussed above, the Application 91300567.4 produces a uniform distribution of sputtered particles.

Various aspects of the invention are set out in the independent Claims which take precedence over the following summary. Besides the optical features set out in the subsidiary Claims, the magnetic means may be movable, the first and second surfaces may be of the same material, the sheath/shielding means and the chamber wall may be at ground potential. The first surface may be defined by a region producing magnetic flux lines generally parallel to said first surface to be sputtered and wherein said second surface is defined by a second region producing a field defining magnetic lines of force generally perpendicular to said second surface. The magnetic means may comprise a pair of opposing magnetic poles orthogonal to said first surface and at least one of said poles may reach saturation such that the magnetic flux returns along the lines of the magnetic field to enrich the plasma density of the magnetron discharge.

The present invention relates to a simple, efficient, vacuum sputter apparatus capable of performing sputter operations at reduced gas operating pressure. European Patent Application No. 91300565.8 describes a sputtering system employing a planar magnetron such as employed in the present invention and is hereby incorporated by reference thereto.

The present invention includes a cathode target having a first, preferably planar, primary sputter surface extending into a vacuum chamber evacuated except for a partial pressure of ionizable, non-reactive sputter gas sufficient to support plasma discharge. The cathode is attached to the negative terminal of a power supply so as to be maintained at a high electric potential with respect to the vacuum chamber, which is maintained at ground. Magnetic means is supported behind the cathode target for producing magnetic flux lines generally parallel to the first surface to be sputtered. The magnetic means is configured so that it produces a closed loop erosion path on the surface of the target. Additionally, a fringing field defines magnetic lines of flux transverse to a second surface of the target and contiguous with the first surface. The second surface is equipotential with the first surface. In the preferred embodiment, the second surface is roughly orthogonal to the first surface; however, it is within the scope of the present invention to construct the cathode target such that the second surface is coplanar with the primary sputter surface. For example, an extended planar cathode can be employed in order to avoid fringing magnetic fields. The target must be sized so that the magnetic field in relation to the magnetic means generally remains concentrated along the extended planar surface of the target. This requires a sufficiently larger target to ensure that the magnetic field is not reflected onto the anode structure, where the fringing field is lost. Accordingly, dark space shields also tend to be used with such extended targets. But a dark space shield around the periphery of the target region of the cathode tends to preclude erosion of the outer edge of the target. The expensive target material is, therefore, not efficiently utilized.

By producing a plasma region at the peripheral edge of the target, it is possible to erode the outer edge of a target uniformly by establishing a magnetic field extending thsough the target to the side of the magnet, rather than through its upper edge. This phenomenon is known as saturation. However, where a dark space shield is in place surrounding the target to prevent contamination these electrons reach a dark space shield or anode surface and are lost to ground.

In the present invention, a dark space shield covers a minimum portion of the second surface to protect against contamination of the deposition material and accumulated deposition of sputter particles on the vacuum apparatus. However, it has been found that by recessing the dark space shield from the target surface an amount sufficient to permit the fringing field to extend to the second surface and to permit a secondary discharge at the second surface, the sputtering process can take place at reduced operating pressure. The plasma generated adjacent the primary sputter surface is enriched both by electrons originating at the second surface and by electrons reflected back to the first surface, both collections of electrons moving along the magnetic flux lines of the fringing field, which lines are transverse to the second surface. For the embodiment in which no magnetic field connects the two regions, cathodic discharge in the second region provides a sourfce of electrons which enrich the plasma of the first region by means of diffusion.

Enhancement of the plasma density along with reduced sputter pressure is accomplished in the present invention using a standard planar magnetron with standard power supply, without recourse to stronger magnets, additional power supplies, additional secondary cathodes, or other additional compensating mechanisms.. Additionally, the present invention permits simultaneous lowering of the sputter pressure while increasing efficiency. This results in lower impedance discharge and less energetic electrons impinging the substrate during film deposition. Thus, less argon gas is incorporated into the deposition film, resulting in a more desirable composition. Because no additional mechanism is required, the second surface is symmetric about the first surface. The plasma enhancement is similarly circumferentially symmetric and uniform and does not disturb a circumferentially uniform magnetron discharge. The film deposited at lower sputter pressure is, therefore, more uniform than that produced by hollow cathode enhanced sputter processes.

Equally important, the pressure in the vacuum chamber is sufficiently reduced so that collision free or "line of sight" transport of the sputter vapor from the target to the substrate is enhanced. High vacuum magnetron sputter deposition is obtained by means of the design of the sputter source and the need for additional means is minimized. Molecular collision typically causes the sputter material to reach the substrate to be coated at relatively low, shallow angles such that the film depostion will not have the desired chemical composition or uniformity. Low pressure sputtering, as obtained by the present invention, eliminates the differential segregation of sputtered compound material so that the stoichiometry of the deposited material is the same as the stoichiometry of the target material. The change in composition of sputtered material such as $MoSi_2$ or TiSi is a well known problem in semiconductor thin film deposition. The lighter of the elements is scattered away from the substrate to a greater degree than the heavier element by many collisions with the argon background gas between the target and the substrate. The change in composition of the material affects the electrical performance of the electrical circuit substantially. Consequently, the deposition of a film having uniform thickness and a composition representing the target material is a significant advantage over the prior art.

In particular, low angle vapor does not contribute to deposition in a via hole or trench and causes the lateral growth of the surface film so as to close off the via hole and limit the step coverage of a metallic interconnect film. The present invention is effective for use in a system utilizing a collimating filter disposed between the target and substrate to be coated, such as disclosed in European Patent Application No. 91300567.4, discussed above. Reduction in scattering provides improved via filling and step coverage without the need for mechanical motion of the substrate, particularly when a collimator is employed.

Sputtering occurs slowly at the second surface of the cathode due to the formation of a glow discharge in this second region. The sputtered material may find its way to the substrate and contaminate the primary material of the coating. In another case, low pressure line of sight operation or line of sight shielding will prevent the material spurred from the side wall from contaminating the deposited film. In this case, a dissimilar material may be used for the side wall of the cathode.

Low pressure sputter operation additionally allows high pumping speed operation of the sputtering vacuum system and a proportional reduction in the background gas present in the vacuum chamber during film deposition. This provides a proportional increase in film quality and in film electrical operation and lifetime, i.e., improved electromigration lifetime for aluminum alloy films.

Although the present invention has been described with respect to a sputter apparatus, it is within the scope of the present invention to apply these principles described to an etch system. Such an system would allow the application of uniform anisotropic and soft argon ion etching of a substrate fixed in place of a target surface.

## BRIEF DESCRIPTION OF THE DRAWINGS

Fig. 1 is a cross sectional view of one embodiment of the magnetron apparatus of the present invention.

Fig. 2 is a cross section view of a second embodiment of the magnetron apparatus of the present invention.

Fig. 3 is a graph showing operating conditions of the present invention.

## DETAILED DESCRIPTION OF THE PREFERRED EMBODIMENTS

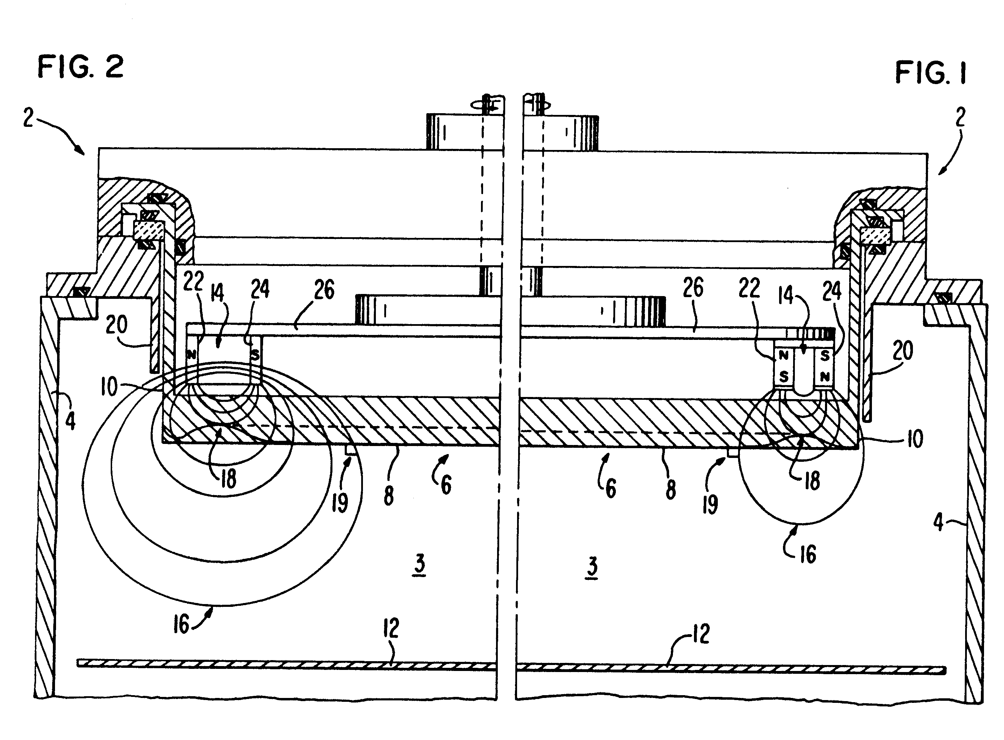

A magnetron apparatus 2, as shown in Figs. 1 and 2, includes an evacuated chamber 3. A cathode 6 is retained within chamber 3 for depositing a film coating on a substrate 12 held in place during processing.

Cathode 6 is attached to the negative terminal of a power supply (not shown) so as to be maintained at high electric potential with respect to the chamber, which is maintained at ground. Cathode 6 includes a first target surface 8 to be eroded made of a material to be sputtered. First surface 8 is preferably planar, although any curved shaped target may be employed. A second surface 10 is contiguous with first surface 8 and in surrounding relation thereto. Second surface 10 is substantially orthogonal to first surface 8. First and second surfaces 8, 10 are mechanically and electrically integral with each other. They may be made of the same material or of different materials bonded to each other. First surface 8 is defined by a region producing magnetic flux lines generally parallel to the first surface. Second surface 10 is defined by a region producing magnetic lines of force generally perpendicular to the second surface.

Substrate 12 is positioned in spaced relationship to first target surface 8. Magnetic means 14 is supported within cathode 6 on the opposite side of first surface 8 from substrate 12. Magnetic means 14 is rotatable about a shaft, as shown in any of several prior art planar magnetron-related systems. One such preferred system is described in European Patent Application No. 91300565. 8, referred to above. Alternatively, the magnetic means may be stationary. The magnetic means produces magnetic flux lines 16 having a component generally parallel to the first surface to be sputtered. Magnetic means 14 is configured so that it produces a closed loop erosion path over surface 8. The erosion profile 18, as seen in Figs. 1 and 2, is uniform.

Primary sputtering occurs where the magnetic flux lines are substantially parallel to the profile of the surface to be sputtered. By producing additional magnetic flux lines at the peripheral edge of first target surface 8, it is possible to erode the outer edge of the target uniformly by establishing a magnetic field extending through the target to the side of the magnet, rather than through its upper edge.

Magnetic means 14 includes a pair of magnet poles 22, 24 affixed to a magnet backing plate 26. The magnetic means establishes fringing fields such that they produce lines of flux transverse to second surface 10 with a substantial component perpendicular thereto. Because of the high potential of cathode 6 in relation to the grounded elements nearby, both electric and magnetic field lines will be transverse to second surface 10, with the strong electric field and nearby plasma of due magnetron discharge helping to give rise to a diode discharge adjacent second surface 10.

Electrons arising from this diode discharge are carried to the magnetron discharge along the magnetic field lines. Similarly, electrons leaving the magnetron discharge are also carried along the magnetic field lines to the second discharge region where they enhance the glow discharge plasma density. These electrons are reflected by the cathode potential of sidewall 4 back to the magnetron discharge. In this way, a mutual enhancement of the electron density of the plasma of the two regions is obtained. Enhancement is additionally obtained due to the eletrons produced in the large volume of area between the two discharges.

As seen in Figs. 1 and 2, magnet poles 22, 24 may have a parallel orientation such that each is directed to produce magnetic flux lines 16 generally parallel to the first surface to be sputtered. Magnetic means 14 is configured so that it produces a closed loop erosion path on surface 8. Alternatively, poles 22, 24 may be oriented perpendicular to each other such that outermost pole 24 is directed toward vacuum chamber sidewall 4.

A dark space shield or conductive sheath 20 extends from the rear of chamber 3 toward first surface 8, covering a minimum portion of second surface 10. The covered surface is in this manner shielded from the impact of electrons which may follow the magnetic field lines from the magnetron discharge and which would tend to set off a diode glow discharge in view of the high potential of surface 10, thus initiating a sputtering mechanism, at the covered surface if it were not thusly covered. Such side surface sputtering would not direct particles directly to the substrate, but rather would tend to undesirably coat adjacent support and chamber walls, and give rise to less desirable shallow angle trajectories, thus generating particulate impurities within the vacuum chamber and detracting from the overall quality of the coating. The dark space shield by preventing such side and surface sputtering and consequent potential particulates, protects against contamination of the deposition material on the vacuum apparatus.

However, a feature of the invention is to recess dark space shield 20 by a certain distance from both first surface 8 and second side surface 10, precisely in order to expose a portion of second surface 10 adjacent to first surface 8 to the action of a diode discharge adjacent the side surface, rather than to prevent this discharge at all portions of second surface 10. The magnetron discharge is expanded so that more of the peripheral portion of first surface 8 is utilized, improving the overall erosion profile. Discharge from the more remote portion of side surface 10 is minimized, because the fringing field is established so as to be concentrated over the leading exposed portion. Yet the main magnetron discharge is significantly enhanced.

It is important that the distance the dark space shield is recessed be controlled properly. In the case of a bonded target, dark space shield 20 terminates short of the interface of the first and second surfaces. In this case, dark space shield 20 extends from the rear region of the vacuum chamber to this interface, preventing contamination of the deposition material on substrate 12 by the non-target material of the second surface, and the accumulated deposition of sputter particles of such non-target material on the vacuum apparatus. As seen in Fig. 1, the dark space shield terminates short of the outermost plane of first surface 8 by a distance greater than about one-half the thickness of cathode 6 in order not to facilitate sputtering to a depth of surface 8 sufficient to compromise its mechanical integrity.

In operation, after chamber 3 is evacuated inert gas at a controlled low pressure, for example, argon at .1 millitorr, is introduced into the vacuum chamber. Cathode 6 is maintained at a negative potential with respect to the interior of the chamber, which is maintained at ground. Magnetron discharge generates a plasma by utilizing crossed magnetic and electric fields. Magnetic means 14 confines the plasma to produce a closed loop erosion path on first surface 8, generally parallel to first surface 8. Additionally, a sufficient fringing field defines magnetic lines of flux transverse, or generally perpendicular to second surface 10 as seen at 19 in Figs. 1 and 2.

Fig. 1 includes a magnetic field arranged so that substantially no field lines 16 pass from first surface 8 to sidewall 4. Electrons emitted by the sidewall glow discharge enrich the magnetron plasma by diffusion to the magnetron discharge region. Fig. 2 illustrates a magnetic field arranged so that substantial perpendicular components 19 arrive at second surface 10. In both cases, the field lines are perpendicular to second surface 10. Electrons arising from the diode discharge at second surface 10 are carried to the magnetron discharge along magnetic flux lines 16. Electrons leaving the magnetron discharge are also carried to the glow discharge region where they enhance the glow discharge plasma density. These electrons are then reflected by the cathode potential of sidewall 4 back to the magnetron discharge. In this way, a mutual enhancement of the electron density of the plasma of the two regions is obtained.

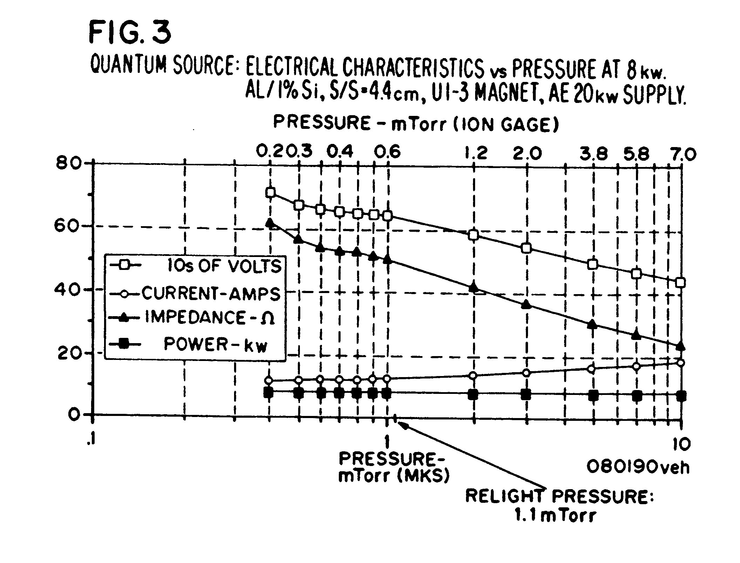

Fig. 3 illustrates quantitatively, the electrical characteristics of the present invention in which dark space shield 20 is recessed approximately 1.3 cm from first surface 8. As seen in the Fig., unlike the prior art, in the present invention, power and rate of deposition remain constant during operation. Typical commercial sputtering operations take place at 0.93 pa and 50-60 Ohms impedance. As discussed above, it is desirable to reduce operating pressure, minimize impedance and maintain constant, high rate of deposition for a given power. The present invention operates effectively at a constant power of 8 kw, pressure of approximately 0.026 Pa, and a rate of deposition of greater than $10^{-4}$cm per minute.

The preferred embodiment of the present invention performs sputtering operations. However, it is within the scope of the present invention to employ the apparatus for etch processes. It is only necessary to reposition the surface of a substrate 12 to be etched in place of the material to be sputtered at first surface 8. The etch system includes means to affix the substrate to the first surface.

**Claims**

1. A magnetron apparatus comprising:

    a cathode extending into a vacuum chamber and having a first surface and a second contiguous surface electrically and mechanically integral with said first surface and extending between said first surface and a wall of said chamber, said chamber being evacuated except for a partial pressure of gas sufficient to support plasma discharge, said cathode being maintained at a negative electric potential with respect to said chamber;

    magnetic means supported within said cathode adjacent to said first surface for producing magnetic flux lines generally parallel to said first surface as well as for providing a field defining magnetic lines of force transverse to said second surface of the cathode, said second surface being equipotential with the first surface; and

    a conductive sheath covering a portion of said second surface and removed from said first and second surfaces, said sheath being maintained at an electrical potential substantially below that of said cathode;

    whereby the plasma generated adjacent to said first surface is enhanced both by electrons originating at the second surface and electrons reflected back to first surface, both moving along the magnetic flux lines.

2. In a vacuum apparatus using magnet means for generating one set of magnetic field lines over a sputter surface protruding into a vacuum chamber in which a plasma generates magnetron discharge by utilizing corssed magnetic and electric fields, and shield means for confining cathodic discharge to desired surfaces, the improvement including a second surface generally transverse to and surrounding said first surface, the exposed portion of said second surface supporting a second cathodic discharge, and means for causing electrons flowing away from the magnetron discharge along the lines of the magnetic field to be reflected by the cathode potential and electrons generated via second discharge so as to return along the lines of the magnetic field to the first sputter surface, thereby enriching the plasma density of the magnetron discharge.

3. In a vacuum apparatus using magnetic means for generating one set of magnetic field lines over a primary surface protruding into a vacuum chamber in which a plasma generates magnetron discharge by utilizing crossed magnetic and electric fields, and shield means for confining cathodic discharge to desired surfaces, the improvement comprising a second surface contiguous with a surrounding said primary surface, the exposed portion of said second surface supporting a second cathodic discharge, wherein electrons flowing away from the second cathodic discharge flow by diffusion and are reflected by the cathode potential to return to said primary sputter surface so as to enrich the plasma density of the magnetron discharge.

4. Magnetron sputter apparatus operating in an evacuated environment, at low gas pressure, comprising a source including a sputter target having a primary sputter surface and being generally transverse thereto, magnet means for generating a magnetic field such that a substantially parallel magnetic field is obtained at the primary sputter surface while a significant transverse magnetic field is established with lines of force transverse to said primary surface and the lines of force of said parallel magentic field, said sidewall surface being equipotential with said primary sputter surface, a portion of said sidewall surface adjacent to said primary surface being exposed such that a second cathodic discharge is facilitated adjacent said exposed portion which enriches the plasma density of the magnetron discharge adjacent the primary sputter surface and said low gas pressure may be reduced as compared to operating without said cathodic discharge.

5. Apparatus as claimed in any one of Claims 1 to 4 in which said sheath electrically shields those portions of the second surface which are covered by said sheath, thereby precluding any plasma discharge adjacent said covered portions as well as any material from said covered portions of said second surface.

6. Apparatus as claimed in any one of Claims 1 to 5 wherein said sheath is removed by a sufficient distance to minimize the density of the fringing field lines intersecting said sheath.

7. Apparatus as claimed in any one of Claims 1 to 6 wherein said first surface and said second surface are constructed of different materials and wherein said first surface is mounted to said second surface.

8. Apparatus as claimed in any one of Claims 1 to 7 wherein said sheath extends from said chamber wall along said second surface toward said first surface, and terminating short of the interface of said surface and second surface.

9. Apparatus as claimed in Claim 8 in which said sheath terminates short of the outermost plane of the first surface by a distance greater than one-half the thickness of said first surface.

10. Apparatus as claimed in Claim 8 wherein said magnetic means provides a sufficient fringing field to cause a magnetic field adjacent the portion of said second surface not covered by said sheath and having a component orthogonal to said second surface which is a substantial fraction of the magnitude of the magnetic field parallel to said first face.

FIG. 2

FIG. 1

2

2

22 14 24 26

26 22 14 24

20

20

10

10

18

19

8

6

8

6

8

19

18

4

6

3

3

16

4

16

12

12

EP 0 482 891 A2

8

# FIG. 3

QUANTUM SOURCE: ELECTRICAL CHARACTERISTICS vs PRESSURE AT 8 kw.
AL/1% Si, S/S=4.4cm, U1-3 MAGNET, AE 20kw SUPPLY.